# EUROPEAN PATENT APPLICATION

(11) **EP 1 684 362 A2**
(43) Date of publication of application: **26.07.2006**
(21) Application number: 06075858.8
(22) Date of filing: 02.12.2004
(51) Int. Cl.: H01L 31/18, H01L 31/032, H01L 27/142

(54) **Process for the production of thin layers, preferably for a photovoltaic cell**

(62) Divisional of application: 04078277.3
(71) Applicant: Technische Universiteit Delft, 2628 BL Delft (NL)
(72) Inventor: Nanu, Marian, 3119 LE Schiedam (NL); Meester, Ben, 2665 DR Bleiswijk (NL); Goossens, Albert, 2311 KE Leiden (NL); Schoonman, Joop, 2242 JH Wassenaar (NL)
(74) Representative: van Loon, C.J.J.

(57) **Abstract**

The invention is directed to a process for the production of a thin layer, preferably for a photovoltaic cell, which cell has at least a first contact layer, a p-type semiconductor layer, an n-type semiconductor layer, or a combined p-type/n-type semiconductor layer, and a second contact layer, said process comprising applying the layer or the various layers on top of each other, wherein at least one of the layers is applied using pulsed spraying of a solution of precursor material for the layer.

## Description

The invention is directed to a process for producing thin layers on a substrate, more in particular thin layers that form part of a photovoltaic cell. Especially the invention is directed to a photovoltaic cell having at least a first contact layer, a p-type semiconductor layer, an n-type semiconductor layer, or a combined p-type/n-type semiconductor layer, and a second contact layer.

In the past years, interest in thin film solar cells based on chalcopyrite semiconductors Cu(In,Ga)(Se,S)₂ (denoted "CIS") is growing. The efficiency obtained with this family of materials can be more than 17%. The performance of these thin film solar cells is excellent, but the process technology involved is very demanding. Vacuum is needed for sputtering or evaporation of both back and front contacts and for deposition of the photoactive materials.

While the performance of CIS cells is very good, there are still a few issues that need to be addressed before a competitive technology becomes available. The energy consumption of the sputter and evaporation processes, along with the slow deposition rates and waiting times for pumping and flushing, frustrate up-scaling of the production process to an industrial level.

This makes the whole process time and energy consuming, which elevates the price of these solar modules close to or even above that of conventional silicon multi-crystalline cells.

A first object of the invention is to provide thin layers on a substrate, which layers can suitably be incorporated in a photovoltaic cell, especially as these layers are easy to produce, while at the same time being very homogeneous and pinhole free, which are important characteristics for such layers.

It is a further object of the present invention to provide a more economic and easy process for the production of photovoltaic cells of the above type, more in particular thin film and 3D cells.

The invention is based on the discovery that it is possible to apply layers on a substrate, especially for photovoltaic cells, by the use of pulsed spraying of solutions of the precursor of the material.

The process of the invention comprises the use of fairly easy technology, compared to the usual methods for producing photovoltaic cells of these types. This technology is based on conventional spraying of a solution of a precursor for the layer(s) onto the substrate. The pulsing is essential in order to obtain sufficient homogeneity and to prevent the occurrence of pinholes, which will lead to short-circuiting of the cells.

The cells are generally composed of at least four component layers, two of which may be combined into one. In the first place there are the two outer contact layers en in between at least a p-type semiconductor layer and an n-type semiconductor layer. These last two layers can in certain circumstances be combined into a mixed layer. In that situation a so-called 3D nanostructured heterojunction cell is obtained, based on an interpenetrating network of the n-type and p-type semiconductor components.

Accordingly the liquid is sprayed onto the substrate, followed by a period during which no spraying occurs. Generally, the duration of the spraying step (pulse) is between land 30 s, preferably between 2 and 15 s. The period between the spraying is preferably between 5 and 60 s, more in particular between 30 and 50 s. The ratio of the length of a pulse to the time between two pulses is between 1 and 10, preferably about 5.

The number of pulses required depend on various parameters, such as layer thickness, droplet size, concentration of the solution and the like. Preferably at least 5 pulses are used, more in particular at least 50 and most preferably between 20 and 200.

Spraying may be accomplished by various means, using conventional nozzle technology, such as the use of one-phase sprayers, two phase sprayers, sonic sprayers or electrostatic sprayers. The size of the droplets from the nozzle is not very critical, nor the size distribution, although care has to be taken to make sure that the size is in agreement with the thickness of the layers to be applied.

As indicated, the photovoltaic cells of the invention comprise various layers. The outer layers are the contact layers, which can both be prepared from the same group of materials, including metals, both noble and non-noble metals (such as Mo, W, Ti, Pt, Au, Ag and Cu), metal oxides and sulfides, as well as other metal compounds, boron compounds, carbon, graphite, organic compounds, organo-metal compounds and polymers. It is possible but not necessary to use the same material for both contact layers. It has to be taken into account that at least one of the layers has to be transparent for light.

In a suitable embodiment one of the contact layers functions as substrate and is composed of a conducting metal film or glass having a conducting coating, such as a transparent conducting oxide.

The other contact layer can be any type. An advantageous material is doped ZnO, especially in combination with an n-type semiconductor layer of ZnO, as this means that after deposition of the ZnO layer, only the dopant has to be added to the spraying system.

As p-type semiconductor layer, materials can be selected from:
A) p-type semiconducting metal oxides, such as Cu₂O, NiO, CuAlO₂.
B) Cu(In,Ga)(S,Se) (family of CIS materials),
C) SnS, SnSe, PbS, PbSe, WS₂, WSe₂, MoS₂, MoSe₂, Cu₂S, CuₓS ; compounds of Cu, Sb, and S (or Se) (CuSbS₂, Cu₂SnS₃, CuSbSe₂, Cu₂SnSe₃); compounds of Pb, Sb, and S (or Se) (PbSnS₃, PbSnSe₃, ...);
D) FeS₂, FeSe₂, FeSi₂,GaSb, InSb, etc

The n-type semiconductor layer is preferably selected from:
A) semiconducting metal oxides, such as TiO₂, SnO₂, ZnO, Fe₂O₃, or WO₃,;
B) Cu(In,Ga)(S,Se) (family of CIS materials);
C) CdS, CdSe, In₂S₃, In₂Se₃, SnS, SnSe, PbS, PbSe, WS₂, WSe₂, MoS₂, MoSe₂;
   compounds of Cu, Sb, and S (or Se) (CuSbS₂, Cu₂SnS₃, CuSbSe₂, Cu₂SnSe₃);
   compounds of Pb, Sb, and S (or Se) (PbSnS₃, PbSnSe₃), or
D) FeS₂, FeSe₂, FeSi₂, GaSb, InSb, etc

It is possible to combine the p-type and the n-type semiconductor layer, as described in : Adv. Mater. **2004** 16, No. 5, March 5, pages 453-456. Surprisingly it has been found that by first applying a nanoporous n-type semiconductor material and using the pulsed spray technology of the invention to impregnate the nanoporous material with the solution of the p-type material or precursor for that material, an excellent combined material is obtained.

In between the various layers other layers may be present, such as primer layers, adhesion layers and buffer layers. Examples of materials for these intermediate layers are:
(A) insulating metal oxides, such as SiO₂, Al₂O₃, ZrO₂, HfO₂, MoO₂, MgO, or Ta₂O₃.
B) semiconducting metal oxides, such as TiO₂, SnO₂, ZnO, Fe₂O₃, or WO₃,
C) electrically conducting metal oxides, such as doped In₂O₃ (ITO), doped SnO₂, doped ZnO, or doped CuAlO₂,
D) insulating sulfides or selenides, such as ZnS, ZnSe, MoS₂, or MoSe₂;
E) semiconducting sulfides or selenides, such as Cu(In,Ga)(S,Se) (family of CIS materials);
   CdS, CdSe, In₂S₃, In₂Se₃, SnS, SnSe, PbS, PbSe, WS₂, WSe₂, MoS₂, or MoSe₂ ;
   compounds of Cu, Sb, and S (or Se) (CuSbS₂, Cu₂SnS₃, CuSbSe₂, Cu₂SnSe₃); compounds of Pb, Sb, and S (or Se) (PbSnS₃, PbSnSe_{3);}
F) wide bandgap semiconductors: CuSCN, CuI, alkalihalogenides
G) diamond, carbon, graphite, or boron compounds,
H) polymers, organic molecules, metal organic molecules.

Depending on the structure of the photovoltaic cell to be produced, the process may be carried out in different ways, although it is essential that at least one layer is produced using the pulsed spraying technology. The solution of the material of a layer or precursor thereof is sprayed in pulses on the hot substrate. The temperature of the substrate is preferably at least 100°C, more in particular between 200 and 500°C. The materials are generally dissolved in a suitable solvent, such as water, organic solvents, mixtures of water and organic solvents, or molten salts. The concentration of the materials in the solution may vary between wide ranges. Preferably it is between 0.001 mole/l and 1 mole/1. It is also possible to spray suspensions or colloids and/or small particles in water, organic solvents, mixtures of water and organic solvents, or molten salts.

The first consideration in defining the process is the nature of the first contact layer. This is the basic layer onto which the various other layers are applied. It is to be noted that there are basically two sequences of applying the respective layers. In the first approach a conducting substrate is provided onto which first the p-type semi conducting layer is applied. Subsequently the n-type semi conducting layer is applied, followed by the second, transparent contact layer. Of course it is possible to include various intermediate layers, as defined above, between the four specified layers. It is also possible, as indicated above to apply the n-type layer as nanoporous material into which the p-type material is impregnated.

In the alternative, one may start with a transparent contact layer, such as a glass with a TCO (transparent conducting oxide) coating, onto which first an n-type semi conducting layer is applied. On top of that the p-type layer is applied, followed by the final contact layer (apart from the intermediate layers).

In Figure 1 a schematic drawing of a 3D solar cell based on a nanocomposite of TiO₂ and CuInS₂ has been given. This embodiment has further been elucidated in Example 5.

Figure 2 shows the incident photon to current efficiency (IPCE) vs. the optical wavelength of the photovoltaic cell of Figure 1. A maximum of 0.8 is reached at 680 nm irradiation, indicating that 80% of the incident photons yield an electron in the external circuit.

Figure 3 shows the current versus voltage curves of the 3D solar cell obtained with spray deposition, shown in Figure 1. When solar irradiation (AM1.5) is present a photovoltage and a photocurrent is generated. The open cell photovoltage is 0.5 volt, the short circuit current is 18 mA cm⁻², and the fill factor is 0.5, which yields an energy conversion efficiency of 5%.

The invention is now elucidated on the basis of the following examples.

### Example 1: TiO₂ and doped TiO₂

Titanium dioxide (TiO₂) and doped TiO₂ can be obtained by spray deposition. As precursor a mixture of titanium tetra isopropoxide (TTIP) (2.4 ml, 97% pure), acetylacetonate (3.6 ml) and ethanol (54 ml, 99.99%) is used. As substrate, commercially available glass with a fluor-doped tin oxide (SnO₂:F) coating is used (typically 5 x 5 cm²), which is held at a temperature of 350 °C during the deposition. To obtain a film thickness of 100 nm, 30 cycles of 10 sec spraying and 1 minute waiting are used. Spraying takes place in air at normal pressure. After the last cycle, the sample is kept at 350 °C for 30 minutes to anneal the TiO₂, which improves the crystal structure and the stoichiometry. To obtain niobium-doped TiO₂ the same procedure is followed but a small fraction of niobium ethoxide is added to the precursor solution. The TiO₂ films are very smooth with a surface roughness of about 5 nm. They are also optically transparent.

### Example 2: CuInS₂ smooth films

CuInS₂ smooth films can be deposited with spay deposition. As substrate, commercially available glass with a fluor-doped tin oxide (SnO₂:F) coating is used (typically 5 x 5 cm²). Also SnO₂:F coated glass substrates with an additional coating of smooth TiO₂ (Example 1) can be used. During the deposition the sample temperature is 300 °C. As precursors an aqueous solution of CuCI dehydrate (95%, 0.01 molar), InCI₃ (98%, 0.008 molar), and SC(NH₂)₂ (thiourea, 98%, 0.12 molar) is used. The pH of the precursor solution is kept close to 7 by adding ammonia. Spay deposition takes place in air at normal pressure, using 30 cycles of spraying 2 seconds, followed by waiting 30 seconds, to obtain a 1 micrometer thin film. After applying the final spray step, the sample is left in air at 250 °C for 1 hour to improve the crystal structure and the stoichiometry of the deposited CuInS₂.

If the pH of the solution is made more alkaline, i.e. pH > 7, by adding additional ammonia, small particles are formed in the precursor solution. This suspension can also be sprayed and yield smooth CuInS₂ films.

### Example 3: Infiltration of nanoporous TiO₂ with CuInS₂

Interpenetrating CuInS₂ films can be deposited with spay deposition. As substrate, commercially available glass with a fluor-doped tin oxide (SnO₂:F) coating is used (typically 5 x 5 cm²). Also SnO₂:F coated glass substrates with an additional coating of smooth TiO₂ (Example 1) can be used. First a 2 micrometer thick coating of nanostructured TiO₂, obtained by doctor-blading of a TiO₂ paste with 50 nm sized particles, is applied. After annealing this paste it forms a nanocrystalline matrix of anatase TiO₂, which can be filled with CuInS₂ by spray deposition. During the spray deposition of CuInS₂ the sample temperature is 300 °C. As precursors an aqueous solution of CuCl dehydrate (95%, 0.001 molar), InCl₃ (98%, 0.0008 molar), and SC(NH₂)₂ (thiourea, 98%, 0.012 molar) is used. The pH of the precursor solution is kept close to 7 by adding ammonia. Spay deposition takes place in air at normal pressure, using 30 cycles of spraying 1 second, followed by waiting 10 seconds, to obtain a 2 micrometer nanocomposite TiO₂/CuInS₂ film. After applying the final spray step, the sample is left in air at 250 °C for 1 hour to improve the crystal structure and the stoichiometry of the deposited CuInS₂. If the pH of the solution is made more alkaline, i.e. pH > 7, by adding additional ammonia, small particles are formed in the precursor solution. This suspension can also be sprayed and yield nanocomposites of TiO₂ and CuInS₂.

### Example 4: ZnO and doped ZnO

Doped and non-doped ZnO thin films can be obtained by spray deposition. Towards this end 1.1 g zinc acetate dihydrate (Zn(CH₃COO)₂ · 2H₂O, 99%) is dissolved in a mixture of 20 ml methanol and 30 ml ethanol. A few drops of glacial acetic acid is added to avoid the precipitation of zinc hydroxide. As substrate, commercially available glass with a fluor-doped tin oxide (SnO₂:F) coating is used (typically 5 x 5 cm²). Also SnO₂:F coated glass substrates with an additional coating of smooth TiO₂ (Example 1) can be used. The deposition temperature is 325 °C during the deposition. Spraying takes place in a pulsed mode with 20 cycles of 5 seconds spray time and 50 seconds delay time using air or oxygen as carrier gas. The obtained film thickness is 1 micrometer. Aluminium-doped ZnO can be obtained by adding 2% aluminium chloride hexahydrate (AlCl₃ · 6H₂O, 98%) to the precursor solution. In this case the substrate temperature must be raised to 350 °C. Also a mixture of 37.5 ml deionized water and 12.5 ml methanol can be used as solvent.

### Example 5: Full sprayed 3D solar cells based on nanocomposites of TiO₂ and CuInS₂

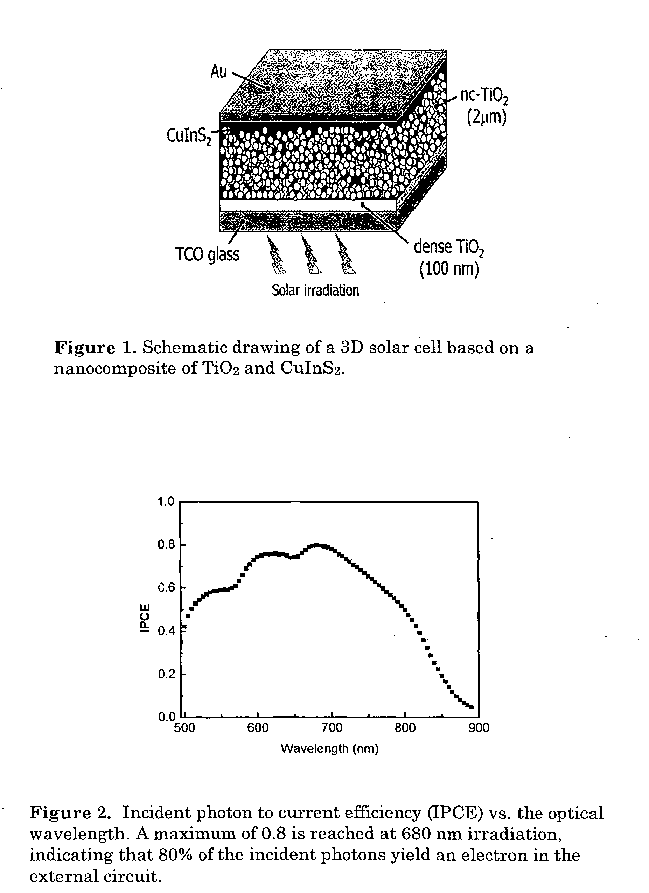

Inorganic 3D solar cells are composed of n-type and p-type semiconductors, which are mixed on a nanometer scale and form an interpenetrating network. The photoactive junction is folded in 3 dimensional space, which explains the name of this device. A schematic drawing of such a device is presented in Figure 1. Starting with fluor-doped tin oxide (SnO₂:F) coated glass, which is commercially available, first a dense TiO₂ film is applied with spray deposition, following the procedure of Example 1. The function of this dense film is to avoid direct contact between the two electrodes, which would lead to short-circuiting of the solar cell. It also acts as an electron transport layer, because holes generated in CuInS₂ cannot be injected into the valence band of TiO₂.

Next nanocrystalline TiO₂ is applied to form the n-type matrix. This can be accomplished with the doctor-blading technique, as described by Nazeeruddin,M.K., Kay,A., Rodicio,I., Humphry-Baker,R., Müller,E., Liska, P., Vlachopoulos, N., and Grätzel, M., *J. Am. Chem. Soc*. **115**, 6382, (1993). It is also possible to use spray deposition to obtain nanocrystalline TiO₂. In this case the procedure of Example 1 must be modified somewhat to obtain a higher reaction rate, i.e. the concentration of the precursor liquid and its composition must be changed along with the substrate temperature. Since the bandgap of anatase TiO₂ is 3.2 eV, the nanocrystalline TiO₂ matrix does not absorb visible light. The pores in nanocrystalline TiO₂ are typically 50 nm in size and the total film thickness is 2 micrometer.

The following step is to apply one or more buffer layers, to improve the chemical and physical properties of the interface between TiO₂ and CuInS₂. Towards this end, a very thin film (10 nm) of indium sulphide (In₂S₃) has been deposited with spray deposition.

Next, CuInS₂ is applied following the procedure of Example 3. CuInS₂ is a p-type semiconductor with a 1.5 eV direct bandgap. It is a black material and absorbs all visible light. The generated conduction band electrons in CuInS₂ are transferred into the conduction band of the TiO₂ nanocrystals, which is possible because the conduction band of CuInS₂ is higher in energy than that of anatase TiO₂. Because of this electron-transfer reaction, electron-hole recombination is quenched almost completely. Indeed large photocurrents are observed. Figure 2 shows the incident photon to current efficiency (IPCE) as a function of wavelength. Optical absorption and photocurrent generation takes place over the entire visible spectrum.

After the pores in TiO₂ are completely filled with CuInS₂ a thin top-layer of CuInS₂ is applied that acts as a hole transport layer. It prevents direct contact between TiO₂ and the top contact material. Also other buffer layers can be applied to improve the chemical and physical properties of the interface between CuInS₂ and the top contact material.

Finally, the top contact is applied to collect the generated holes in CuInS₂. A thin film of graphite, applied with doctor blading, can be used. As alternative it is possible to spray deposit ZnO following the procedure of Example 4. Non-doped ZnO is deposited first followed by doped ZnO. Because ZnO and doped ZnO are optically transparent it is possible to produce the solar cell in reverse order. In this case, light is not coming from the bottom (see Figure 1) but from above. When both contact layers are made from transparent materials, light can enter the cell from the bottom and from above. In that case light harvesting is a more efficient, leading to a better solar cell performance.

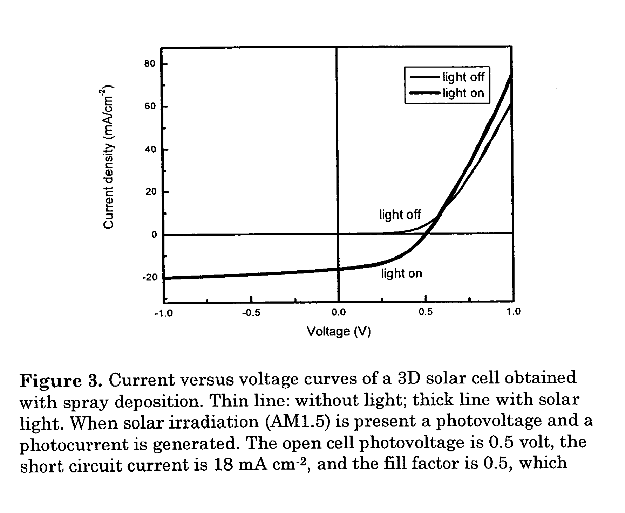

In this 3D nanocomposite solar cell, electrons percolate through the nanocrystalline TiO₂ network to reach the optically transparent bottom contact. The holes percolate through the infiltrated CuInS₂ and reach the top contact. In a well- designs cell, the external quantum efficiency, i.e. flux of electrons divided by the incoming flux of photons, is more than 80%, which demonstrate that the percolation of electrons and holes indeed takes place without losses. When solar irradiation (AM1.5) is applied a photovoltage and a photocurrent is generated. The open-cell photovoltage is 0.5 volt, the short-circuit current is 18 mA cm⁻², and the fill factor is 0.5, which yields an energy conversion efficiency of 5%. The current versus voltage response of a 3D solar cell is shown in Figure 3.

## Claims

1. Process for producing a substrate provided with a layer, said process comprising spraying a precursor material onto the substrate, wherein the layer is applied using pulsed spraying of a liquefied, such as in a solution or in a suspension, precursor material for the layer.

2. Process for the production of a photovoltaic cell, which cell has at least a first contact layer, a p-type semiconductor layer, an n-type semiconductor layer, or a combined p-type/n-type semiconductor layer, and a second contact layer, said process comprising sequentially applying the various layers on top of each other, wherein at least one of the semiconductor layers is applied using pulsed spraying of a liquefied, such as in a solution or in a suspension, precursor material for the layer.

3. Process according to claim 2, wherein all layers are applied using pulsed spraying.

4. Process according to claim 2 or 3, wherein one or more buffer layers are present between the contact and/or semiconductor layers.

5. Process according to claim 2-4, which process comprises providing the first contact layer as substrate, applying the p-type semiconductor layer on the substrate by pulsed spraying, optionally with an intermediate layer between the substrate and the p-type semiconductor layer, applying the n-type semiconductor layer on top of the p-type semiconductor layer by pulsed spraying, optionally with an intermediate layer between the p-type semiconductor layer and the n-type semiconductor layer, followed by applying the second contact layer on top of the n-type semiconductor layer by pulsed spraying, optionally with an intermediate layer between the n-type semiconductor layer and the second contact layer.

6. Process according to claim 2-5, which process comprises providing the first contact layer as substrate, applying the n-type semiconductor layer on the substrate by pulsed spraying, optionally with an intermediate layer between the substrate and the n-type semiconductor layer, applying the p-type semiconductor layer on top of the n-type semiconductor layer by pulsed spraying, optionally with an intermediate layer between the p-type semiconductor layer and the n-type semiconductor layer, followed by applying the second contact layer on top of the p-type semiconductor layer by pulsed spraying, optionally with an intermediate layer between the p-type semiconductor layer and the second contact layer.

7. Process according to claim 5 or 6, wherein intermediate layers can comprise:
A) insulating metal oxides, such as SiO₂, Al₂O₃, ZrO₂, HfO₂, MoO₂, MgO, or Ta₂O₃.
B) semiconducting metal oxides, such as TiO₂, SnO₂, ZnO, Fe₂O₃, or WO₃,
C) electrically conducting metal oxides, such as doped In₂O₃ (ITO), doped SnO₂, doped ZnO, or doped CuAlO₂,
D) insulating sulfides or selenides, such as ZnS, ZnSe, MoS₂, or MoSe₂;
E) semiconducting sulfides or selenides, such as Cu(In,Ga)(S,Se) (family of CIS materials);
CdS, CdSe, In₂S₃, In₂Se₃, SnS, SnSe, PbS, PbSe, WS₂, WSe₂, MoS₂, or MoSe₂ ;
compounds of Cu, Sb, and S (or Se) (CuSbS₂, Cu₂SnS₃, CuSbSe₂, Cu₂SnSe₃);
compounts of Pb, Sb, and S (or Se) (PbSnS₃, PbSnSe₃);
F) wide bandgap semiconductors: CuSCN, CuI, alkalihalogenides
G) diamond, carbon, graphite, or boron compounds,
H) polymers, organic molecules, metal organic molecules.

8. Process according to claim 2-7, wherein the p-type semiconductor layer is selected from .
A) p-type semiconducting metal oxides, such as Cu₂O, NiO, CuAlO₂.
B) Cu(In,Ga)(S,Se) (family of CIS materials),
C) SnS, SnSe, PbS, PbSe, WS₂, WSe₂, MoS₂, MoSe₂, Cu₂S, CuₓS;
compounds of Cu, Sb, and S (or Se) (CuSbS₂, Cu₂SnS₃, CuSbSe₂, Cu₂SnSe₃);
compounts of Pb, Sb, and S (or Se) (PbSnS₃, PbSnSe₃);
D) FeS₂, FeSe₂, FeSi₂, GaSb, InSb.

9. Process according to claim 2-8, wherein the n-type semiconductor layer is selected from:
A) semiconducting metal oxides, such as TiO₂, SnO₂, ZnO, Fe₂O₃, WO₃;
B) Cu(In,Ga)(S,Se) (family of CIS materials);
C) CdS, CdSe, In₂S₃, In₂Se₃, SnS, SnSe, PbS, PbSe, WS₂, WSe₂, MoS₂, MoSe₂ ,
compounds of Cu, Sb, and S (or Se) (CuSbS₂, Cu₂SnS₃, CuSbSe₂, Cu₂SnSe₃);
compounds of Pb, Sb, and S (or Se), such as (PbSnS₃, PbSnSe_{3.});
D) FeS₂, FeSe₂, FeSi₂, GaSb, InSb.

10. Process according to claim 2-9, wherein the first and second contact layer is selected from .
A) Mo, MoS₂, MoSe₂, W, WO₃;
B) Ti, TiO₂, TiS₂;
C) other non noble metals and their compounds;
D) noble metals: Pt, Au, Ag, Cu;
E) carbon, graphite, boron compounds;
F) polymers, organic molecules, metal organic molecules.

11. Process according to claim 1-10, wherein the liquified precursor material is a solution or suspension of the material in water, organic solvents, mixtures of water and organic solvents, or a molten salts, .

12. Process according to claim 1-11, wherein the thickness of the layer, preferably the p-type semiconductor layer is between 10 nm and 10 µm.

13. Process according to claim 2-12, wherein the thickness of the n-type semiconductor layer is between 10 nm and 10 µm.

14. Process according to claim 1-13, wherein the length of the pulse is between 1 and 30 s, preferably between 2 and 15 s.

15. Process according to claim 1-14, wherein the time between each pulse is between 5 and 60 s, preferably between 30 and 50 s.

16. Process according to claim 1-15, wherein the ratio of the length of a pulse to the time between two pulses is between 1 and 10, preferably about 5.

17. Process according to claim 1-16, wherein the solution is sprayed using at least one spraying nozzle.

18. Process according to claim 1-16, wherein the solution is sprayed using electrostatic spraying.

19. Process according to claim 2-18, wherein the photovoltaic cell is a thin film cell or a 3D photovoltaic cell.
